# EUROPEAN PATENT APPLICATION

(11) **EP 4 550 410 A1**
(43) Date of publication of application: **07.05.2025**
(21) Application number: 23830910.8
(22) Date of filing: 25.05.2023
(51) Int. Cl.: H01L 23/473, B60R 16/02, H05K 7/20, H02M 7/48

(54) **UNIT**

(30) Priority: 01.07.2022 JP 2022107066
(71) Applicant: Jatco Ltd., Shizuoka 417-8585 (JP)
(72) Inventor: OSHIDARI, Toshikazu, Fuji-shi, Shizuoka 417-8585 (JP)
(74) Representative: Hoefer & Partner Patentanwälte mbB
(86) International application number: PCT/JP2023/019477
(87) International publication number: WO 2024/004459

(57) **Abstract**

[PROBLEMS] Provided is a novel structure of a use form of a fiber body.

[SOLUTIONS] A unit includes an electric circuit unit, a cooler through which a coolant passes, and a fiber body, the electric circuit unit is cooled by the cooler, and the fiber body has a portion disposed at a coolant inlet of the cooler.

## Description

### TECHNICAL FIELD

The present invention relates to a unit.

### BACKGROUND ART

Patent Document 1 discloses a cooling member in which metal fibers are filled in an accommodating body and cooling is performed using a high thermal conductivity of the metal fibers.

### PRIOR ART DOCUMENT

### PATENT DOCUMENT

Patent Document 1: JP 2019-009433 A

### SUMMARY OF INVENTION

### PROBLEM TO BE SOLVED BY THE INVENTION

As a result of diligent studies, the present inventors have found that when a coolant passes through fibers, turbulence is generated, and cooling is promoted by an effect of the turbulence. Furthermore, it has been found that when the coolant passes through a surface of the fibers, turbulence is generated due to disorder of the surface of the fibers, and the cooling is promoted by an effect of the turbulence. According to the findings, it means that the cooling performance can be enhanced regardless of the material of a fiber body, and the fiber body can be used in a form completely different from concepts described in Patent Document 1.

An object of the present invention is to provide a novel structure of a use form of a fiber body based on the above concepts.

### MEANS FOR SOLVING THE PROBLEM

According to an aspect of the present invention, a unit includes an electric circuit unit, a cooler through which a coolant passes, and a fiber body, the electric circuit unit is cooled by the cooler, and the fiber body has a portion disposed at a coolant inlet of the cooler.

### EFFECT OF THE INVENTION

According to an aspect of the present invention, turbulence is generated in a cooler, and the cooling efficiency of an electric circuit unit through the coolant can be improved by providing a fiber body at a coolant inlet. Accordingly, it is possible to provide a novel structure of a use form of a fiber body.

### BRIEF DESCRIPTION OF DRAWINGS

[FIG. 1] FIG. 1 is a perspective view of a unit according to an embodiment of the present invention.
[FIG. 2] FIG. 2 is a view taken along an arrow II in FIG. 1.
[FIG. 3] FIG. 3 is a cross-sectional view taken along a line III-III in FIG. 1.
[FIG. 4] FIG. 4 is a perspective view of a unit according to a modification of the embodiment of the present invention.
[FIG. 5] FIG. 5 is a view taken along an arrow V in FIG. 4.
[FIG. 6] FIG. 6 is a cross-sectional view taken along a line VI-VI in FIG. 4.

### DESCRIPTION OF EMBODIMENTS

Hereinafter, a water-cooled electric circuit unit 1 as a unit according to an embodiment of the present invention will be described with reference to the drawings.

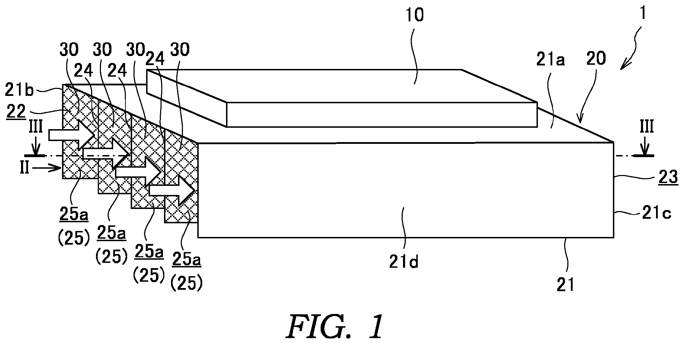

First, the water-cooled electric circuit unit 1 will be described with reference to FIGS. 1 to 3.

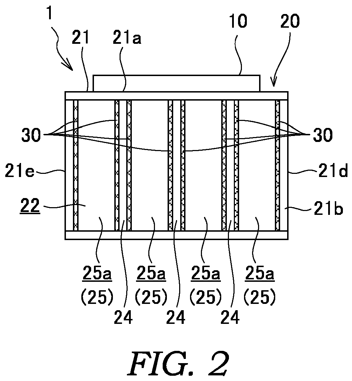

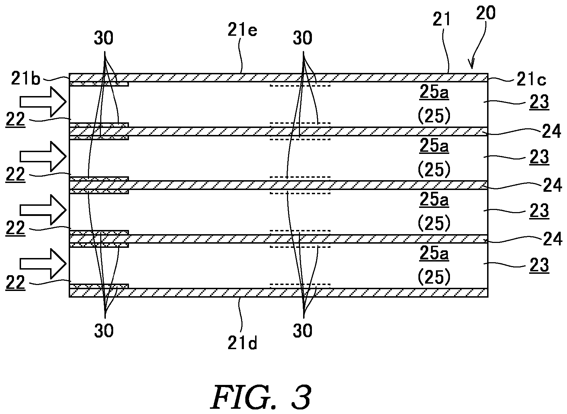

FIG. 1 is a perspective view of the water-cooled electric circuit unit 1. FIG. 2 is a view taken along an arrow II in FIG. 1. FIG. 3 is a cross-sectional view taken along a line III-III in FIG. 1.

As shown in FIG. 1, the water-cooled electric circuit unit 1 includes a power module 10 as an electric circuit unit, a cooler 20, and fiber bodies 30.

The power module 10 includes a plurality of switching elements (not shown) such as an insulated gate bipolar transistor (IGBT) constituting an inverter circuit that controls a rotating electrical machine (not shown) serving as a drive source of a vehicle. The power module 10 is in contact with the cooler 20 and is cooled by the cooler 20. The contact is a concept including not only direct contact but also indirect contact (thermal contact) with a metal plate or the like having high thermal conductivity interposed therebetween.

The cooler 20 cools the power module 10 that generates heat during operation. In the cooler 20, coolant water as a coolant for cooling the power module 10 passes. The coolant is not limited to the coolant water, and may be another liquid such as coolant oil. The cooler 20 includes a main body 21, inlets 22 as a coolant inlet, outlets 23 as a coolant outlet, and a plurality of partition plates 24.

The main body 21 is formed in a substantially rectangular parallelepiped shape. The main body 21 includes a top surface 21a and four side surfaces 21b, 21c, 21d, and 21e (see FIG. 3). A coolant water passage 25 serving as a coolant passage is defined in the main body 21.

As shown in FIGS. 1 and 2, a power module 10 is provided on the top surface 21a. As shown in FIG. 3, the side surface 21b and the side surface 21c are provided to face each other. The side surface 21d and the side surface 21e are provided to face each other, and are provided to connect the side surface 21b and the side surface 21c.

Each inlet 22 opens to the side surface 21b of the main body 21. Coolant water that flows into the coolant water passage 25 and cools the power module 10 is introduced from the inlet 22.

Each outlet 23 opens to the side surface 21c of the main body 21. Coolant water that flows out of the coolant water passage 25 after cooling the power module 10 in the coolant water passage 25 is led out from the outlet 23.

As shown in FIG. 1, the plurality of (here, three) partition plates 24 are provided, and the coolant water passage 25 is divided into a plurality of (here, four) parallel passages 25a. Each of the parallel passages 25a is formed to have a substantially rectangular flow passage cross section. The partition plates 24 are provided between a pair of side surfaces 21d and 21e of the main body 21. The partition plates 24 are arranged at equal intervals between the pair of side surfaces 21d and 21e.

As shown in FIG. 3, the fiber body 30 is formed in a substantially rectangular shape. The fiber bodies 30 are provided along the flow of the coolant water, that is, parallel to a liquid flow direction. The fiber bodies 30 are provided in a range from the inlets 22 in the coolant water passage 25 to a predetermined length. That is, the fiber bodies 30 have a portion disposed in the inlets 22 of the cooler 20. The fiber bodies 30 are attached to inner surfaces of the side surfaces 21d and 21e of the main body 21 and both surfaces of the partition plates 24. Accordingly, the fiber bodies 30 are provided on both side surfaces of all the parallel passages 25a.

Each of the fiber bodies 30 is, for example, a copper fiber, but may be another metal fiber, a carbon fiber, a resin fiber, or the like. Since the coolant water passes along surfaces of the fiber bodies 30, turbulence is generated in the coolant water due to disorder of the surfaces caused by the fibers.

As described above, by providing the fiber bodies 30 in the inlets 22, turbulence is caused inside the cooler 20, and the cooling efficiency of the power module 10 via the coolant water can be improved. Accordingly, it is possible to provide a novel structure of a use form of the fiber body 30. As the cooling efficiency is improved, a cooler having equivalent cooling performance can be reduced in size.

Since the coolant water flows along the surface sides of the fiber bodies 30, turbulence can be generated by the fiber bodies 30, and the pressure loss of the coolant water can be reduced. Thus, the energy required to circulate the coolant water can be reduced.

The fiber bodies 30 are disposed to overlap only a part of the power module 10 as viewed in an intersecting direction intersecting the liquid flow direction in which the coolant water flows in the cooler 20. That is, the power module 10 has a portion offset from the fiber bodies 30.

In consideration of the turbulence effect, turbulence is generated at a downstream side of the fiber bodies 30 offset from the fiber bodies 30. Therefore, by disposing the power module 10 to have a portion offset from the fiber bodies 30, the power module 10 can be overlapped with a turbulence generation region, and the cooling efficiency can be improved.

That is, since the turbulence generated in the coolant water is propagated to the downstream side, it is possible to improve the cooling efficiency in a range reaching the downstream side by simply providing the fiber bodies 30 in the inlets 22.

As shown in FIG. 3, when the length of the power module 10 is large with respect to the turbulence generated in the coolant water by the fiber bodies 30, the fiber bodies 30 may be further provided in the middle of the coolant water passage 25. In this way, by intermittently providing the plurality of fiber bodies 30 along the flow of the coolant water in the coolant water passage 25, turbulence can be generated in the coolant water over the entire length direction of the power module 10.

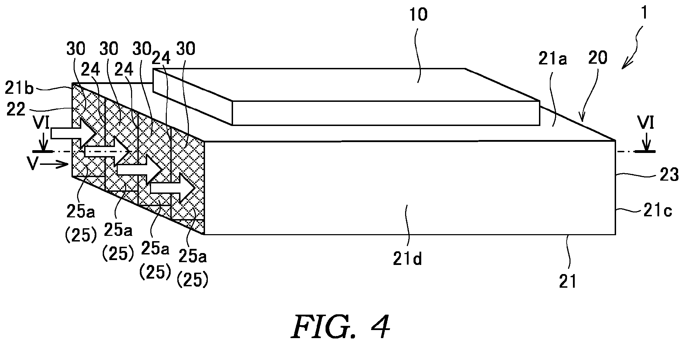

Next, the water-cooled electric circuit unit 1 as a unit according to a modification of the embodiment of the present invention will be described with reference to FIGS. 4 to 6. In the following modifications, differences from the above-described embodiment are mainly described, and configurations having similar functions are denoted by the same reference numerals and the description thereof is omitted.

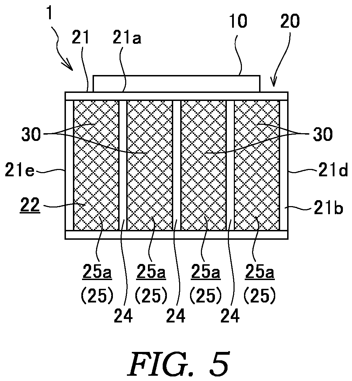

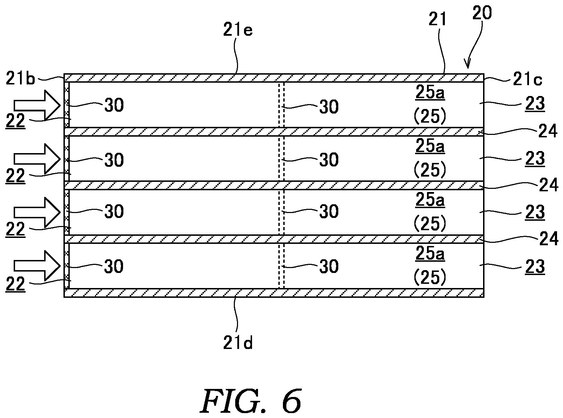

FIG. 4 is a perspective view of the water-cooled electric circuit unit 1. FIG. 5 is a view taken along an arrow V in FIG. 4. FIG. 6 is a cross-sectional view taken along a line VI-VI in FIG. 4.

As shown in FIGS. 4 and 5, the water-cooled electric circuit unit 1 includes the power module 10 as an electric circuit unit, the cooler 20, and the fiber bodies 30.

Each of the fiber bodies 30 is formed in a substantially rectangular shape. The fiber bodies 30 are provided in the inlets 22 of the parallel passages 25a in the coolant water passage 25. The fiber bodies 30 are provided along the intersecting direction intersecting the liquid flow direction in which the coolant water flows. Accordingly, the coolant water passes through the fiber bodies 30 and is introduced into the cooler 20.

When the coolant water passes through the fiber bodies 30, turbulence is generated in the coolant water due to the fibers. Since the fiber bodies 30 are provided to substantially perpendicularly intersect with the liquid flow direction of the coolant water, it is desirable to use fiber bodies having rougher meshes than fiber bodies provided along the liquid flow direction of the above-described embodiment.

As described above, as in the above-described embodiment, by providing the fiber bodies 30 in the inlets 22, turbulence is caused inside the cooler 20, and the cooling efficiency of the power module 10 via the coolant water can be improved. Accordingly, it is possible to provide a novel structure of a use form of the fiber body 30.

According to this modification, the fiber bodies 30 can be easily attached to the cooler 20 only by attaching the fiber bodies 30 to the inlets 22 of the parallel passages 25a.

As shown in FIG. 6, when the length of the power module 10 is large with respect to the turbulence generated in the coolant water by the fiber bodies 30, the fiber bodies 30 may be further provided in the middle of the coolant water passage 25. In this way, by intermittently providing the plurality of fiber bodies 30 along the flow of the coolant water in the coolant water passage 25, turbulence can be generated in the coolant water over the entire length direction of the power module 10.

The configuration and effects of the present embodiment described above are described together below.
(1) The water-cooled electric circuit unit 1 includes the power module 10, the cooler 20 through which coolant water passes, and the fiber bodies 30, the power module 10 is cooled by the cooler 20, and each of the fiber bodies 30 has a portion disposed at the inlets 22 of the cooler 20.
   According to this configuration, by providing the fiber bodies 30 in the inlets 22, turbulence is caused inside the cooler 20, and the cooling efficiency of the power module 10 via the coolant water can be improved. Accordingly, it is possible to provide a novel structure of a use form of the fiber body 30.
(2) In addition, the power module 10 has a portion offset from the fiber bodies 30 as viewed in an intersecting direction intersecting the liquid flow direction in which the coolant water flows in the cooler 20.
   According to this configuration, in consideration of the turbulence effect, turbulence is generated at a downstream side of the fiber bodies 30 offset from the fiber bodies 30. Therefore, by disposing the power module 10 to have a portion offset from the fiber bodies 30, the power module 10 can be overlapped with the turbulence generation region, and the cooling efficiency can be improved.
(3) The coolant water flows along the surface sides of the fiber bodies 30.
   According to this configuration, turbulence can be generated by the fiber bodies 30, and the pressure loss of the coolant water can be reduced.
(4) The coolant water passes through the fiber bodies 30 and is introduced into the cooler 20.

According to this configuration, the fiber bodies 30 can be easily attached to the cooler 20.

Although the embodiment of the present invention has been described above, the above embodiment is merely an application example of the present invention and is not intended to limit the technical scope of the present invention to the specific configuration of the above embodiment.

### DESCRIPTION OF REFERENCE SIGNS

- 1: water-cooled electric circuit unit (unit)

- 10: power module (electric circuit unit)
- 20: cooler
- 22: inlet (coolant inlet)
- 30: fiber body

## Claims

1. A unit comprising:
an electric circuit unit;
a cooler through which a coolant passes; and
a fiber body, wherein
the electric circuit unit is cooled by the cooler, and
the fiber body has a portion disposed at a coolant inlet of the cooler.

2. The unit according to claim 1, wherein
the electric circuit unit has a portion offset from the fiber body as viewed in an intersecting direction intersecting a liquid flow direction in which the coolant flows in the cooler.

3. The unit according to claim 1 or 2, wherein
the coolant flows along a surface side of the fiber body.

4. The unit according to claim 1 or 2, wherein
the coolant is introduced into the cooler through the fiber body.
